# EUROPÄISCHE PATENTSCHRIFT

(11) **EP 2 494 655 B1**
(45) Veröffentlichungstag und Bekanntmachung des Hinweises auf die Patenterteilung: **18.07.2018**
(21) Anmeldenummer: 10779263.2
(22) Anmeldetag: 29.10.2010
(51) Int. Cl.: H01Q 1/22, H01Q 21/06, H01L 23/66

(54) **ANTENNENANORDNUNG ZUR ÜBERTRAGUNG VON SIGNALEN**
ANTENNA ARRANGEMENT FOR SIGNAL TRANSMISSION
AGENCEMENT D'ANTENNE DE TRANSMISSION DE SIGNAUX

(30) Priorität: 29.10.2009 DE 102009051143
(43) Veröffentlichungstag der Anmeldung: 05.09.2012
(73) Patentinhaber: Technische Universität Dresden, 01069 Dresden (DE)
(72) Erfinder: PLETTEMEIER, Dirk, 01187 Dresden (DE); JENNING, Michael, 01277 Dresden (DE); LIANG, Ting-Jung, 01069 Dresden (DE)
(74) Vertreter: Lippert Stachow Patentanwälte Rechtsanwälte
(86) Internationale Anmeldenummer: PCT/EP2010/066485
(87) Internationale Veröffentlichungsnummer: WO 2011/051456

(56) Entgegenhaltungen:
- EP-A1- 2 071 663
- WO-A2-2007/149819
- WO-A2-2008/030208
- US-A1- 2005 093 145
- US-B1- 6 373 447

## Beschreibung

Die Erfindung betrifft eine Antennenanordnung zur Übertragung von Signalen, bestehend aus mehreren Antennen, welche in einer Ebene zu einer Chipoberfläche beabstandet angeordnet sind.

Zur Abstrahlung und zum Empfang elektromagnetischer Wellen, beispielsweise im Bereich der drahtlosen Kommunikation, werden Antennen benötigt. Diese technische Anordnung wandelt als eine senderseitig angeordnete Antenne leitungsgebundene elektromagnetische Wellen in sogenannte Freiraumwellen um, welche sich als elektromagnetische Wellen von der Antenne in den Raum ausbreiten.

Empfängerseitig wandelt die Antenne die als Freiraumwelle ankommenden elektromagnetischen Wellen zurück in leitungsgebundene elektromagnetische Wellen, die Antenne ist somit ein Wandler zwischen Leitungs- und Freiraumwellen sowie umgekehrt. Wesentlich dafür ist die Anpassung des Wellenwiderstandes der Leitung an den Wellenwiderstand des freien Raumes.

In modernen Geräten im Bereich der Kommunikationstechnik besteht die Notwendigkeit, Antennen mit kleinen oder kleinsten Abmessungen mit den für die Signalverarbeitung vorgesehenen Halbleiterchips oder Bestandteilen des Halbleiterchips zu verbinden, um deren Funktionalitäten zu gewährleisten.

Aus der US 7,221,052 B2 ist eine mit einem Halbleiterchip verbundene Antenne bekannt, wobei die Antenne auf der Oberseite des Halbleiterchips ausgebildet ist.

Diese Lösung weist den Nachteil auf, dass sie ein Bestandteil des Chips selbst ist. Dadurch ist eine Nutzung mit unterschiedlichen Chips nur bedingt möglich, da der Entwurf der Antennenstruktur bereits beim Entwurf des Chips durchgeführt werden muss.

Aus der US 2009/0207090 ist eine auf der Oberseite eines Halbleiterchips angeordnete, aus vier gleich aufgebauten Antennen bestehende Antennenanordnung bekannt. Diese Anordnung verbessert die Einsatzmöglichkeiten, da sie unabhängig vom Chip ist und somit für eine Vielzahl verschiedener Chips genutzt werden kann. Die Nachteile dieser Anordnung liegen darin, dass die Chips in der gleichen Lage wie die Antennenelemente liegen. Dies führt zu einer Vergrößerung der Fläche, die das gesamte Bauteil, bestehend aus Antenne, Chip und Gehäuse auf einer Platine benötigt. Ein weiterer Nachteil dieser Anordnung ist, dass sowohl die Chips die Strahlungscharakteristik der Antennen beeinflussen als auch die abgestrahlte Leistung Einfluss auf die Chips hat.

Aus der US 6.373.447 B1 ist eine Antennenanordnung zur Übertragung von Signalen bekannt, welche mittels einer Strukturanordnung über einem Chip befestigt ist. Weiterhin ist aus dieser Druckschrift bekannt, zwei Antennen nebeneinander in der gleichen, von der Chipoberfläche beabstandeten Ebene anzuordnen.

Offenbart ist hierbei, dass die erste Antenne als Sende- und die zweite Antenne als Empfangsantenne genutzt wird oder dass die erste und die zweite Antenne in Serie geschaltet als eine aus zwei Teilen bestehende Gesamtantenne betrieben wird. Der Erfindung liegt somit die Aufgabe zugrunde, eine Antennenanordnung zur Übertragung von Signalen anzugeben, welche eine verbesserte Richtcharakteristik sowie einen höheren Antennengewinn aufweist, einfach zu fertigen, robust und kostengünstig ist.

Gemäß der Erfindung wird die Aufgabe mit einer Antennenanordnung zur Übertragung von Signalen der eingangs genannten Art dadurch gelöst, dass die Ausrichtung der Antennen zwischen zwei benachbarten Ebenen unterschiedlich ist, wobei die Antennenanordnung aus einer ersten Antennenteilanordnung und einer zweiten Antennenteilanordnung besteht, wobei die erste Antennenteilanordnung über der zweiten Antennenteilanordnung angeordnet ist, wobei die erste Antennenteilanordnung aus Patchantennen und die zweite Antennenteilanordnung aus mehrlagigen Vivaldi-Antennen besteht oder die erste Antennenteilanordnung aus Patchantennen und die zweite Antennenteilanordnung aus einer Reihe von seitlichen Patchantennen besteht oderdie erste Antennenteilanordnung aus Schleifenantennen und die zweite Antennenteilanordnung aus mehrlagigen Vivaldi-Antennen besteht oder die erste Antennenteilanordnung aus Cavity-Backed Strukturen und die zweite Antennenteilanordnung aus mehrlagigen Vivaldi-Antennen besteht. Gemäß der Erfindung werden mehrere Antennen pro Ebene angeordnet, wobei die Antennenanordnung mindesten zwei Ebenen umfasst. Durch eine derartige Anordnung der Antennen zu einer Antennenanordnung wird die Richtcharakteristik verbessert.

Die Erfindung ermöglicht sowohl eine Kombination gleicher als auch unterschiedlicher Antennen in einem Antennensystem, um die Leistungsfähigkeit des Gesamtsystems zu verbessern. Die Verbesserungen umfassen dabei die Erhöhung der Abdeckung des ausleuchtbaren Raumes, wobei sich die Einzelantennensysteme im Allgemeinen nicht negativ beeinflussen, sowie die Verringerung des Energieverbrauchs.

Wesentliche Vorteile sind dabei die Erhöhung der Abdeckung, d.h. der Raum, welcher das Gesamtantennensystem in der Lage ist auszuleuchten (Abstrahlcharakteristik) und die kompakte und robuste Bauform.

In einer Ausgestaltung der Erfindung ist vorgesehen, dass die Ausrichtung der Antennen in einer Ebene gleich ist.

In einer Ausführung der Erfindung ist vorgesehen, dass die Ausrichtung der Antennen in einer Ebene unterschiedlich ist.

Die in einer Ebene der Antennenanordnung angeordneten Einzelantennen können in der Hauptrichtung ihrer abgegebenen Strahlstärke gleich ausgerichtet angeordnet werden. Derart kann eine Richtwirkung der Antennenanordnung in eine bevorzugte Strahlrichtung der Antennen erreicht werden.

In einer anderen Ausführung können die Einzelantennen einer Ebene bezogen auf ihre Hauptrichtung ungleich ausgerichtet werden. Mittels verschiedener Hautrichtungen kann die Richtcharakteristik der Antennenanordnung beispielsweise derart verändert werden, dass sich ein bevorzugter Bereich oder Sektor der Richtwirkung oder eine nahezu gleichmäßige Richtwirkung (Kugelcharakteristik) nach allen Seiten ergibt.

In einer weiteren Ausgestaltung der Erfindung ist vorgesehen, dass die Ausrichtung der Antennen zwischen zwei benachbarten Ebenen unterschiedlich ist.

Erfindungsgemäß ist es möglich, die Ausrichtung der Einzelantennen einer Ebene gleich oder verschiedenartig zur Ausrichtung der Einzelantennen einer anderen Ebene zu gestalten. Bei einer gleichen Ausrichtung zwischen zwei Ebenen verbessert sich wiederum die Richtwirkung der gesamten Antennenanordnung in der Richtung der Ausrichtung der Einzelantennen während mittels einer verschiedenartigen Ausrichtung der Ebenen ein bevorzugter Bereich oder eine gleichmäßigere allseitige Richtwirkung erreichen lässt.

In einer besonderen Ausführung der Erfindung ist vorgesehen, dass die Antennen zweier benachbarter Ebenen deckungsgleich oder versetzt zueinander angeordnet sind.

Wenn mehrere Ebenen der Antennenanordnung eine planare Struktur aufweisen, so können die Ebenen mehrlagig übereinander angeordnet werden. Dabei ist es möglich, die einzelnen Ebenen bündig oder versetzt zueinander anzuordnen, wobei wiederum die Richtcharakteristik des Systems beeinflusst werden kann.

In einer Ausführung der Erfindung ist vorgesehen, dass die Ebenen eine kreisförmige oder n-eckige Grundfläche mit n ≥ 3 aufweisen.

Es ist möglich, die Grundfläche einer oder mehrerer Ebenen zu variieren, so kann diese beispielsweise als Dreieck, Viereck oder Achteck ausgeführt werden.

In einer weiteren Ausführung der Erfindung ist vorgesehen, dass die Ebenen eine Quader- oder eine Pyramidenstumpfstruktur bildend übereinander angeordnet sind.

Bei einer rechteckigen Grundfläche einer Ebene der Antennenanordnung entsteht, bei einer Anordnung der Ebenen aufeinander oder übereinander, entweder eine Quaderstruktur oder für den Fall, dass die Abmessungen der übereinander angeordneten Ebenen immer kleiner werden, eine Pyramidenstumpfstruktur.

In einer speziellen Ausführung der Erfindung ist vorgesehen, dass die Ankopplung der Antennenanordnung an den Chip mittels Kontakten, induktiv oder kapazitiv erfolgt.

Zur Übertragung von Signalen zwischen den Einzelantennen oder der Antennenanordnung und dem Chip müssen beide miteinander verbunden sein. Eine Signalübertragung zwischen Chip und Antenne kann beispielsweise durch eine elektrisch leitende Verbindung in Form von Kontakten oder Drähten erfolgen. Eine andere Form der Verbindung ist eine kapazitive oder eine induktive Kopplung zwischen Antenne und Chip.

In einer speziellen Ausführungsform der Erfindung ist vorgesehen, dass die Antennenanordnung mittelbar auf dem Chip oder in einem den Chip deckelartig abdeckenden Gehäuseteil angeordnet ist.

Die Erfindung stellt in einer besonderen Ausführung ein Gehäuse für einen Chip zur Verfügung, welches gleichzeitig eine erfindungsgemäße Antennenanordnung beinhaltet. Dabei sind mehrere Möglichkeiten der Ausgestaltung dieser Antennenanordnung denkbar, beispielsweise Kombinationen zweier oder mehrerer gleichartiger oder verschiedenartiger Antennen (beispielsweise Mikrostreifen-Patchantennen, Vivaldi-Antennen) in einer oder mehreren Ebenen. Auch eine Anordnung jeweils mehrerer Antennen in mindestens zwei verschiedenen Ebenen zu einem Antennensystem ist möglich. Bei der Kombination verschiedener Antennen zu einer derartigen Antennenanordnung ist ein Ziel die Vergrößerung des sogenannten ausgeleuchteten Bereichs oder der Richtcharakteristik der Antenne.

Gemäß der Erfindung kann jede einzelne Antenne der Antennenanordnung mit einer eigenen Ansteuereinheit verbunden sein. Hier wird eine einzelne Antenne zu einer festgelegten Zeit, gesteuert durch ihre zugeordnete Ansteuereinheit, aktiv.

Eine andere Möglichkeit besteht darin, mehrere Antennen einer oder mehrerer Ebenen der Antennenanordnung zusammenzuschalten und mit einer Ansteuerschaltung zu verbinden. Somit werden mehrere derart zusammengeschaltete Antennen, welche auch als Cluster bezeichnet werden, von einer gemeinsamen Ansteuerschaltung angesteuert.

Durch die Zusammenschaltung mehrerer einzelner Antennen der Antennenanordnung kann die Anzahl der benötigten Verstärker reduziert und somit der Energiebedarf des Systems verringert werden.

Diese Zusammenschaltung mehrerer Antennen kann statisch erfolgen. Hierbei werden beispielsweise einmalig festgelegte Verbindungen, welche geschaltet werden sollen, zwischen der Ansteuerschaltung und den Antennen hergestellt. Dadurch wird die Antennenanordnung oder ein Teil der Antennenanordnung (Cluster) zu einer festgelegten Zeit aktiv.

Es ist aber auch eine vollständig dynamische Arbeitsweise möglich, derart dass die elektrischen Amplituden und Phasen aller Antennen und/oder Cluster zeitgleich und unabhängig voneinander mittels einer entsprechenden Ansteuereinheit gesteuert werden.

Die Erfindung soll nachfolgend anhand eines Ausführungsbeispiels näher erläutert werden. In den zugehörigen Zeichnungen zeigt
- Fig. 1: eine Ansicht einer erfindungsgemäßen Antennenanordnung mit zwei übereinander angeordneten Antennenteilanordnungen,
- Fig. 2: eine Ansicht der ersten Antennenteilanordnung von oben,
- Fig. 3: eine Ansicht der zweiten Antennenteilanordnung,
- Fig. 4: eine Darstellung einer Antennenanordnung, bestehend aus 6x6 Antennenelementen, Teilantennen oder Einzelantennenelemente, wobei hier cavity backed dipole antennas verwendet werden,
- Fig. 5: eine Ausschnittsvergrößerung eines 6x6 Arrays aus der Figur 4 mit darunter angeordneten Vivaldi-Antennen, dreilagig ausgeführt,
- Fig. 6: eine Richtcharakteristik des Arrays aus Figur 4, alle Elemente sind dabei gleichphasig und mit gleicher Amplitude gespeist und
- Fig. 7: eine Richtcharakteristik des Arrays aus Figur 4, hierbei wurden die Phasen der Einzelelemente so eingestellt, dass die Strahlschwenkung erreicht wird.

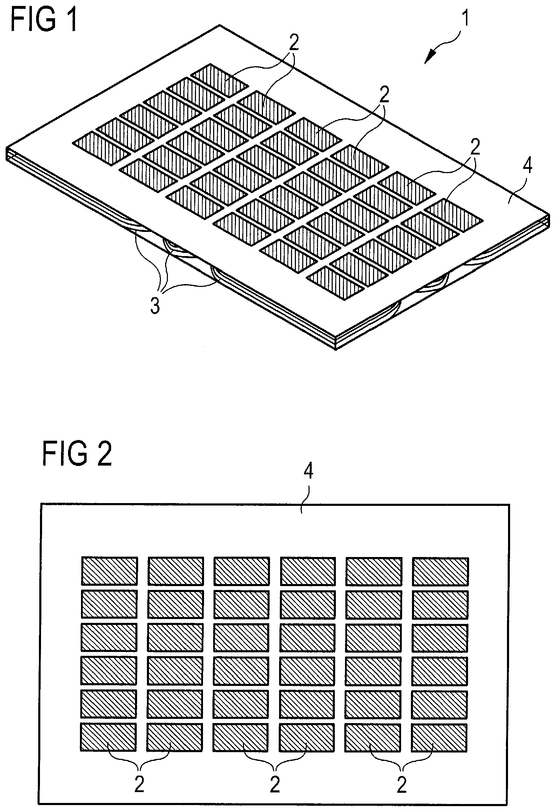

Figur 1 zeigt eine erfindungsgemäße Antennenanordnung 1, welche beispielsweise in einem einen Chip deckelartig abdeckenden Gehäuseteil 4 eines Chipgehäuses angeordnet ist. Das Chipgehäuse 4 ist nur auszugsweise und nur schematisch dargestellt.

Figur 1 zeigt die Antennenanordnung 1 in einer isometrischen Ansicht. Die Antennenanordnung 1 besteht aus zwei Antennenteilanordnungen 2 und 3. Die erste Antennenteilanordnung 2 umfasst die oberste Ebene. In dieser sind mehrere Einzelantennen in mehreren Reihen und Spalten angeordnet dargestellt. Im Beispiel sind 36 Stück jeweils in einer rechteckform dargestellt. In dieser Ausführung der Erfindung sind die Antennen der obersten Ebene als Mikrostreifen-Patchantennen ausgeführt und gleich ausgerichtet angeordnet.

Unter der ersten Antennenteilanordnung 2 ist die zweite Antennenteilanordnung 3 dargestellt. Die Antennenteilanordnung 2 umfasst zwei Ebenen, in denen jeweils mehrere Vivaldi-Antennen pro Ebene in unterschiedlichen Richtungen ausgerichtet angeordnet sind.

Die Ausrichtung der Vivaldi-Antennen zwischen den beiden benachbarten Ebenen ist deckungsgleich. Es ist jedoch auch denkbar, die zweite Antennenteilanordnung 3 nur aus einer Ebene oder aus drei Ebenen bestehend auszuführen, wobei die Ausrichtung der Vivaldi-Antennen von Ebene zu Ebene verschieden ist. Weiterhin ist es möglich, in einer Ebene sowohl Vivaldi-Antennen als auch Mikrostreifen-Patchantennen anzuordnen.

Figur 2 zeigt eine Ansicht der Antennenanordnung von oben auf das Chipgehäuse 4, wobei eine die oberste Ebene abdeckende Gehäuse- oder Schutzschicht nicht dargestellt ist.

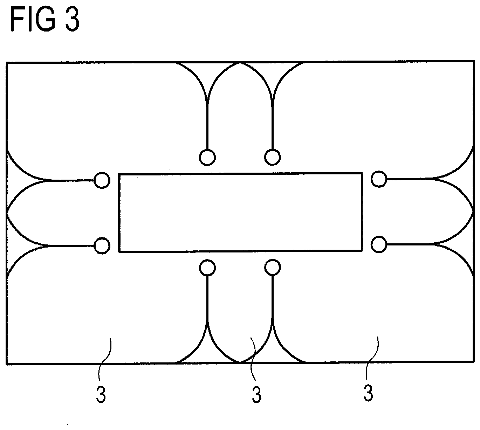

In der Figur 3 ist die Antennenanordnung in einer Ansicht von unten dargestellt. Die aus mehreren Vivaldi-Antennen bestehende Antennenteilanordnung 3 erstreckt sich dabei bis zum Rand des Chipgehäuses 4. Die Ausrichtung der Vivaldi-Antennen erfolgte in einer Ebene eines nicht dargestellten Koordinatensystems in einem Winkel von 0, 90, 180 und 270 Grad.

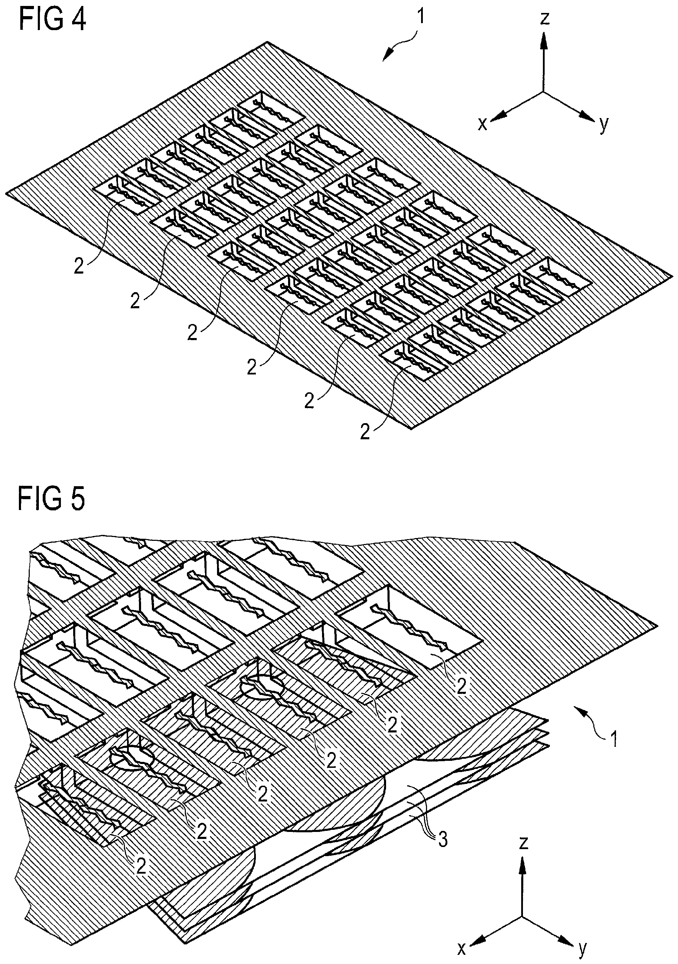

Die Figur 4 zeigt eine Darstellung eines 6x6 Antennenarrays, beispielsweise als erste Antennenteilanordnung 2, in welcher sogenannte "cavity backed dipole antennas" verwendet wurden. Die Ausrichtung aller Antennen dieser Antennenteilanordnung 2 ist gleich.

Die Figur 5 zeigt eine Ausschnittsvergrößerung der ersten, aus einer Ebene bestehenden, Antennenteilanordnung 2 aus der Figur 4. Unter der ersten Antennenteilanordnung 2 ist eine aus drei Ebenen bestehende zweite Antennenteilanordnung 3 angeordnet. In dieser sind Vivaldi-Antennen gleich ausgerichtet und deckungsgleich übereinander angeordnet.

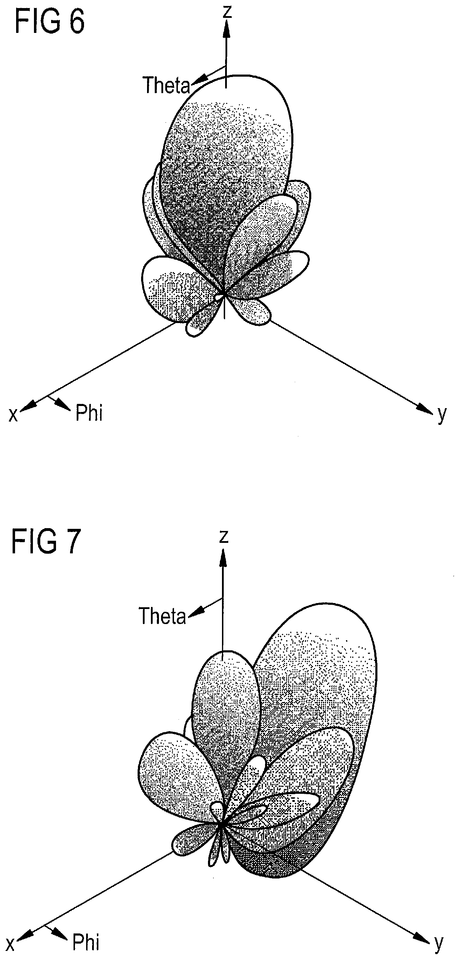

Die Figur 6 zeigt eine dreidimensionale grafische Darstellung der Strahlungscharakteristik (oder Richtcharakteristik) der erfindungsgemäßen Antennenanordnung 1 aus der Figur 4. Die Darstellung ist nur eine Prinzipdarstellung verschiedener Keulen in einem räumlichen Koordinatensystem. Auf eine Darstellung der Feldstärke wurde verzichtet. Dargestellt ist der Fall einer gleichphasigen und mit gleicher Amplitude gespeisten aus 36 Teilantennen bestehenden Antennenanordnung 1.

In der Figur 7 ist eine weitere dreidimensionale Prinzipdarstellung einer Richtcharakteristik abgebildet. Diese bezieht sich ebenfalls auf die in der Figur 4 dargestellte Antennenanordnung 1. In diesem Fall wurden die Phasen der 36 Einzelantennen der Antennenanordnung 1 derart eingestellt, dass die dargestellte Strahlschwenkung erreicht wird. In der Figur 7 ist die maximal erreichbare Strahlschwenkung mit einer derartigen Anordnung aufgezeigt. Eine weitere Strahlschwenkung ist mittels einer in der Figur 5 dargestellten Antennenanordnung 1 möglich. In dieser sind zwei aus verschiedenartigen Antennen bestehende Antennenteilanordnungen 2 und 3 dargestellt. Durch die unterschiedlichen Antennenarten sowie eine unterschiedliche Ausrichtung der Antennen in einer Ebene oder zwischen den Ebenen wird eine gezielte Beeinflussung der Strahlformung und der Ausrichtung erreicht.

Die Erfindung stellt eine Antennenanordnung 1 bereit, welche direkt im Gehäuse eines Chips 4, vorzugsweise in einem dem Chip deckelartig abdeckenden Gehäuseteil angeordnet ist.

Derartige Chips können beispielsweise Halbleiterchips für Anwendungen im Millimeterwellbereich sein. Dabei ist es für die Antennen der Antennenanordnung 1 unerheblich, welche Signalinformationen mit ihr abgestrahlt oder empfangen werden.

Ist die Antennenanordnung 1 ein Teil des Chipgehäuses, werden keine Verbindungen zwischen den Anschlüssen des Halbleiterchips (Pins) und einer separaten, außerhalb des Chips angeordneten Antenne notwendig, was zu einer Vereinfachung des Chipdesigns und zu einer Reduzierung der Kosten führt. Weiterhin treten keine elektrischen Verluste durch die oben aufgeführten Verbindungen auf. Somit wird eine Reduzierung der Verlustleistung erreicht. Darüber hinaus verringert sich die Zahl notwendinger Verbindungsleitungen auf der den Chip tragenden Platine, was zu einer Reduzierung des notwendigen Platzbedarfs und der Kosten führt.

Die erfindungsgemäße Antennenanordnung 1 kann aber auch direkt auf den Chip, beispielsweise nur durch eine Isolationsschicht von diesem getrennt, aufgebracht werden und bildet somit keinen Bestandteil des Chipgehäuses.

Eine weitere Möglichkeit der Platzierung der Antennenanordnung 1 ist die Anordnung direkt auf dem Halbleiterchip als eine Teilbaugruppe des Chips selbst oder die Platzierung in einer den Halbleiterchip seitlich abdeckenden Chipgehäusewand.

Derartige Antennenanordnungen 1 können beispielsweise zur Übertragung von großen Datenmengen zwischen PC, Drucker, Maus, Tastatur, Bildschirm, TV-Gerät, Hi-Fi-Geräten, Beamer, mediznischen Analysegeräten u.a. eingesetzt werden. Dabei ist beispielsweise bei der Verwendung des 60 GHz Frequenzspektrums eine Datenübertragung bis zu einer Entfernung von etwa 10 Metern möglich.

Weiter besondere Merkmale und Ausführungsformen sind nachfolgend aufgeführt:
Möglich sind Kombinationen zweier (oder mehrerer) unterschiedlicher Antennenanordnungen, z.B. planare, geschichtete Systeme. Dadurch wird eine Vergrößerung des ausgeleuchteten Raumes (Erhöhung der Abdeckung) sowie eine kompakte Bauform der Antennenanordnung erreicht.

Integration der Antennenanordnung im Chipgehäuse oder eine Implementierung der Erfindung auf dem Chip selbst sind möglich.

Verwendung einer oder mehrerer mehrlagiger Antennenanordnungen sind möglich, wobei die Anzahl der Lagen ≥ 1 ist.

Das Speisenetzwerk zur Ansteuerung der Einzelantennen befindet sich im Gehäuse selbst. Dieses kann dabei ebenfalls mehrlagig ausgeführt sein. Mögliche Leitungsstrukturen sind CPS, CPW, (gekoppelte) Mikrostreifen, Schlitzleitung oder Streifenleitung. Die Überkopplung von der Zuleitung auf die strahlenden Aperturen kann unterschiedlich erfolgen, z.B. galvanisch, kapazitiv oder induktiv gekoppelt.

Vorgesehen sind galvanische, kapazitive oder induktive Verbindungen zwischen Gehäuse und dem Chip.

Bei der Ansteuerung der Einzelantennen der Antennenanordnung 1 sind nachfolgende Ausführungen vorgesehen:
∘ Fest verdrahtet, d.h. es ist keine Strahlschwenkung möglich.
∘ Komplett unabhängig, d.h. die elektrischen Phasen und Amplituden jedes Antennenelements aller Antennensysteme sind frei und unabhängig voneinander einstellbar.
∘ Eine Kombination der zuvor genannten Möglichkeiten, d.h. es werden kleinere Gruppen (Cluster), bestehend aus fest verdrahteten Antennenelementen eines oder mehrerer Antennensysteme gebildet, wobei die elektrischen Phasen und Amplituden der einzelnen Gruppen unabhängig voneinander einstellbar sind.
∘ Einzelne Antennenelemente oder Cluster sind zu-/abschaltbar bzw. Aktivierung beliebig kombinierbar um eine diskretisierte Strahlschwenkung zu erreichen.
∘ Leistung der einzelnen Leistungsverstärker lässt sich wahlweise auf die Antennenelemente bzw. Cluster aufteilen und kombinieren. Gleiches gilt auch für die Empfangsverstärker.
∘ Bei der Strahlformung und Strahlschwenkung kann es sich um eine reine Steuerung oder auch um eine Regelung handeln, die adaptiv ausgeführt werden kann.

Es können die nachfolgend aufgeführten Antennentypen zum Einsatz kommen:
∘ Bei einer Antennenanordnung nach Figur 1:
   ▪ Patchantennen
   ▪ Dielektrische Resonatorantennen
   ▪ Schleifenantennen, Rhombische Antennen
   ▪ "Gedruckte" Dipole, Yagi-Antennen
   ▪ Cavity-Backed Strukturen
   ▪ als Hornantennen angedeutete Vias in der obersten Substratschicht mit Speiselementen (Vgl. US 7444734 B2)
∘ Bei einer Antennenanordnung nach Figur 3:
   ▪ aufgeweitete Schlitzantennen (mögliche Formen der Aufweitung: stufenweise, linear, exponentiell (Vivaldi-Antenne), etc.)
   ▪ Dipole
   ▪ Yagi-Antennen
   ▪ seitlich montierte Patchantennen
   ▪ neben dem Gehäuse montierte/an das Gehäuse geklebte (oder anders befestigt) dielektrische Resonatorantennen
∘ Sinnvolle Kombinationen von mehrlagigen Teilantennensystemen können erfindungsgemäß bestehen aus:
   ▪ Patchantennen (oben) mit Vivaldis (mehrlagig)
   ▪ Patchantennen (oben) mit einer Reihe Patchantennen seitlich
   ▪ Schleifenantennen (oben) mit Vivaldis (mehrlagig)

Die Anwendungen einer derartigen Antennenanordnung kann beispielsweise im Bereich der Kommunikation (hohe Datenraten, kurze Kontaktzeiten), der Sensor-Technik (hohe Auflösung), der Medizin (z.B. abbildende Systeme), des Radars, der Mustererkennung sowie in der industriellen Fertigung erfolgen.

### Bezugszeichenliste

- 1: Antennenanordnung
- 2: erste Antennenteilanordnung
- 3: zweite Antennenteilanordnung
- 4: Chipgehäuses (Teil des Deckels)

## Patentansprüche

1. Antennenanordnung (1) zur Übertragung von Signalen, bestehend aus mehreren Antennen, welche in einer Ebene zu einer Chipoberfläche beabstandet angeordnet sind, wobei die Antennenanordnung mehrere Ebenen aufweist, wobei in jeder Ebene mehrere Einzelantennen angeordnet sind, **dadurch gekennzeichnet, dass** die Ausrichtung der Antennen zwischen zwei benachbarten Ebenen unterschiedlich ist, wobei die Antennenanordnung aus einer ersten Antennenteilanordnung (2) und einer zweiten Antennenteilanordnung (3) besteht, wobei die erste Antennenteilanordnung über der zweiten Antennenteilanordnung angeordnet ist,
wobei die erste Antennenteilanordnung aus Patchantennen und die zweite Antennenteilanordnung aus mehrlagigen Vivaldi-Antennen besteht oder
die erste Antennenteilanordnung aus Patchantennen und die zweite Antennenteilanordnung aus einer Reihe von seitlichen Patchantennen besteht oder
die erste Antennenteilanordnung aus Schleifenantennen und die zweite Antennenteilanordnung aus mehrlagigen Vivaldi-Antennen besteht oder
die erste Antennenteilanordnung aus Cavity-Backed Strukturen und die zweite Antennenteilanordnung aus mehrlagigen Vivaldi-Antennen besteht.

2. Antennenanordnung nach Anspruch 1, **dadurch gekennzeichnet, dass** die Ausrichtung der Antennen in einer Ebene gleich ist.

3. Antennenanordnung nach Anspruch 1, **dadurch gekennzeichnet, dass** die Ausrichtung der Antennen in einer Ebene unterschiedlich ist.

4. Antennenanordnung nach einem der Ansprüche 1 bis 3, **dadurch gekennzeichnet, dass** die Antennen zweier benachbarter Ebenen deckungsgleich oder versetzt zueinander angeordnet sind.

5. Antennenanordnung nach einem der Ansprüche 1 bis 4, **dadurch gekennzeichnet, dass** die Ebenen eine kreisförmige oder n-eckige Grundfläche mit n ≥ 3 aufweisen.

6. Antennenanordnung nach einem der Ansprüche 1 bis 5, **dadurch gekennzeichnet, dass** die Ebenen eine Quader- oder eine Pyramidenstumpfstruktur bildend übereinander angeordnet sind.

7. Antennenanordnung nach einem der Ansprüche 1 bis 6, **dadurch gekennzeichnet, dass** die Ankopplung der Antennenanordnung an den Chip mittels Kontakten, induktiv oder kapazitiv erfolgt.

8. Antennenanordnung nach einem der Ansprüche 1 bis 7, **dadurch gekennzeichnet, dass** die Antennenanordnung mittelbar auf dem Chip oder in einem den Chip deckelartig abdeckenden Gehäuseteil angeordnet ist.

9. Antennenanordnung nach einem der Ansprüche 1 bis 8, **dadurch gekennzeichnet, dass** jede Antenne mit einer separaten Ansteuereinheit verbunden ist oder dass mehrere Antennen mit einer gemeinsamen Ansteuereinheit verbunden sind.

## Claims

1. Antenna arrangement (1) for transmitting signals, consisting of a plurality of antennas arranged in a plane at a distance from a chip surface, wherein the antenna arrangement has a plurality of planes, wherein a plurality of individual antennas are arranged in each plane, **characterized in that** the orientation of the antennas between two adjacent planes is different
wherein the antenna arrangement consists of a first antenna subarrangement (2) and a second antenna subarrangement (3),
wherein the first antenna subarrangement is arranged above the second antenna subarrangement ,
wherein the first antenna subarrangement consists of patch antennas and the second antenna subarrangement consists of multilayered Vivaldi antennas or
the first antenna subarrangement consists of patch antennas and the second antenna subarrangement consists of a series of lateral patch antennas or the first antenna subarrangement consists of loop antennas and the second antenna subarrangement consists of multilayered Vivaldi antennas or
the first antenna subarrangement consists of cavity-backed structures and the second antenna subarrangement consists of multilayered Vivaldi antennas.

2. Antenna arrangement according to Claim 1, **characterized in that** the orientation of the antennas in a plane is the same.

3. Antenna arrangement according to Claim 1, **characterized in that** the orientation of the antennas in a plane is different.

4. Antenna arrangement according to any of Claims 1 to 3, **characterized in that** the antennas of two adjacent planes are arranged congruently or in an offset manner with respect to one another.

5. Antenna arrangement according to any of Claims 1 to 4, **characterized in that** the planes have a circular or n-gonal basic area where n ≥ 3.

6. Antenna arrangement according to any of Claims 1 to 5, **characterized in that** the planes are arranged one above another to form a parallelepipedal or a truncated pyramid structure.

7. Antenna arrangement according to any of Claims 1 to 6, **characterized in that** the coupling of the antenna arrangement to the chip is effected by means of contacts, inductively or capacitively.

8. Antenna arrangement according to any of Claims 1 to 7, **characterized in that** the antenna arrangement is arranged indirectly on the chip or in a housing part covering the chip like a cover.

9. Antenna arrangement according to any of Claims 1 to 8, **characterized in that** each antenna is connected to a separate drive unit, or **in that** a plurality of antennas are connected to a common drive unit.

## Revendications

1. Arrangement d'antennes (1) destiné à la transmission de signaux, composé de plusieurs antennes qui sont disposées dans un plan en étant espacée d'une surface de puce, l'arrangement d'antennes possédant plusieurs plans, plusieurs antennes individuelles étant disposées dans chaque plan, **caractérisé en ce que** l'orientation des antennes entre deux plans voisins est différente,
l'arrangement d'antennes se composant d'un premier arrangement partiel d'antennes (2) et d'un deuxième arrangement partiel d'antennes (3),
le premier arrangement partiel d'antennes étant disposé au-dessus du deuxième arrangement partiel d'antennes,
le premier arrangement partiel d'antennes étant constitué d'antennes planaires et le deuxième arrangement partiel d'antennes étant constitué d'antennes Vivaldi ou
le premier arrangement partiel d'antennes étant constitué d'antennes planaires et le deuxième arrangement partiel d'antennes étant constitué d'une rangée d'antennes planaires latérales ou
le premier arrangement partiel d'antennes étant constitué d'antennes cadres et le deuxième arrangement partiel d'antennes étant constitué d'antennes Vivaldi multicouches ou
le premier arrangement partiel d'antennes étant constitué de structures à cavité et le deuxième arrangement partiel d'antennes étant constitué d'antennes Vivaldi multicouches.

2. Arrangement d'antennes selon la revendication 1, **caractérisé en ce que** les orientations des antennes dans plan sont identiques.

3. Arrangement d'antennes selon la revendication 1, **caractérisé en ce que** les orientations des antennes dans un plan sont différentes.

4. Arrangement d'antennes selon l'une des revendications 1 à 3, **caractérisé en ce que** les antennes de deux plans voisins sont disposées de manière coïncidente ou décalée les unes par rapport aux autres.

5. Arrangement d'antennes selon l'une des revendications 1 à 4, **caractérisé en ce que** les plans possèdent une surface de base circulaire ou à n côtés, avec n ≥ 3.

6. Arrangement d'antennes selon l'une des revendications 1 à 5, **caractérisé en ce que** les plans sont disposés les uns au-dessus des autres en formant une structure parallélépipédique ou de pyramide tronquée.

7. Arrangement d'antennes selon l'une des revendications 1 à 6, **caractérisé en ce que** l'accouplement de l'arrangement d'antennes au niveau de la puce est réalisé au moyen de contacts inductifs ou capacitifs.

8. Arrangement d'antennes selon l'une des revendications 1 à 7, **caractérisé en ce que** l'arrangement d'antennes est disposé indirectement sur la puce ou dans une partie de boîtier qui recouvre la puce à la manière d'un couvercle.

9. Arrangement d'antennes selon l'une des revendications 1 à 8, **caractérisé en ce que** chaque antenne est reliée à une unité de commande séparée ou en ce que plusieurs antennes sont reliées à une unité de commande commune.
